# EUROPEAN PATENT APPLICATION

(11) **EP 4 811 660 A1**
(43) Date of publication of application: **23.09.2026**
(21) Application number: 24891644.7
(22) Date of filing: 02.10.2024
(51) Int. Cl.: H03K 5/01, H02M 3/155

(54) **PULSE SHAPING DEVICE AND PULSE SHAPING METHOD USING SAME**

(30) Priority: 13.11.2023 KR 20230156581
(71) Applicant: Korea Electrotechnology Research Institute, Changwon-si, Gyeongsangnam-do 51543 (KR)
(72) Inventor: JANG, Sung Roc, Changwon-si, Gyeongsangnam-do 51543 (KR); KIM, Hyoung Suk, Changwon-si, Gyeongsangnam-do 51543 (KR); YU, Chan Hun, Changwon-si, Gyeongsangnam-do 51543 (KR)
(74) Representative: Cabinet Beau de Loménie
(86) International application number: PCT/KR2024/015006
(87) International publication number: WO 2025/105697

(57) **Abstract**

Disclosed are a pulse formation device capable of forming various shapes of pulses and a pulse formation method using the same. The pulse formation device (10) includes: at least one first power module (100) connected to one end (L1) of a load terminal (L); and at least one second power module (200) connected to the other end (L2) of the load terminal (L) and the first power module (100), wherein the first power module (100) comprises a plurality of first voltage sources (110) and a plurality of switches (S1 to S4) independently turned on or off, the second power module (200) comprises a plurality of second voltage sources (210) and a plurality of switches (S5 to S8) independently turned on or off, and a difference between a first output voltage (V1) of the first power module (100) and a second output voltage (V2) of the second power module (200) is generated as an output voltage (Vo) between both ends of the load terminal (L).

## Description

### [Technical Field]

The present invention relates to a pulse formation device and a pulse formation method using the same, and more particularly to a pulse formation device capable of forming pulses of various shapes and a pulse formation method using the same.

### [Background Art]

In general, a high-voltage pulse generation circuit is required for supply of pulsed power to a load device that requires high voltage, such as various test instruments or plasma generators (PSII and the like).

A conventional pulse generation circuit may be configured to apply a pulse having a certain level of voltage to a load through a switch and a charge capacitor.

However, the conventional pulse generation circuit can only apply a positive voltage pulse waveform to the load instead of a negative voltage pulse waveform and can neither adjust the voltage level of the applied pulse nor form pulse waveforms of various shapes.

### [Disclosure]

### [Technical Problem]

It is an object of the present invention to provide a pulse formation device capable of forming a negative voltage pulse waveform or pulse waveforms of various shapes at various voltage levels, and a pulse formation method using the same.

### [Technical Solution]

In accordance with one aspect of the present invention, a pulse formation device (10) includes at least one first power module (100) connected to one end (L1) of a load terminal (L) and at least one second power module (200) connected to the other end (L2) of the load terminal (L) and the first power module (100).

The first power module (100) may include a plurality of first voltage sources 110 and a plurality of switches (S1 to S4) independently turned on/off.

The second power module (200) may include a plurality of second voltage sources (210) and a plurality of switches (S5 to S8) independently turned on/off.

A difference between a first output voltage (V1) of the first power supply module (100) and a second output voltage (V2) of the second power supply module (200) may be generated as an output voltage Vo between both ends of the load terminal (L).

A plurality of the first power module (100) may be provided.

The plurality of first power modules (100) may be connected in series.

A plurality of the second power module (200) may be provided.

The plurality of second power modules (200) may be connected in series.

The first power module (100) may include two first voltage sources (110) and first to fourth switches (S1 to S4) disposed on four legs (LG1) of an H-bridge circuit, respectively.

The second power module (200) may include two first voltage sources (210) and fifth to eighth switches (S5 to S8) disposed on four legs (LG1) of an H-bridge, respectively.

Each of the switches (S1 to S8) may include a MOSFET.

Each of the first voltage source (110) and the second voltage source (210) may be a DC voltage source.

The first voltage source (110) and the second voltage source (210) may be connected to the load terminal (L) with opposite polarities.

The pulse formation device may further include a controller configured to control on/off of the switches (S1 to S8).

Each of the first voltage sources (110) and each of second voltage source (210) may output the same magnitude of voltage.

### [Advantageous Effects]

Embodiments of the present invention provide a pulse formation device capable of forming a negative voltage pulse waveform or pulse waveforms of various shapes at various voltage levels and a pulse formation method using the same.

### [Description of Drawings]

FIG. 1 is a circuit diagram of a pulse formation device according to one embodiment of the present invention.
FIG. 2 is a graph depicting one embodiment of a control scheme of switches of the pulse formation device shown in FIG. 1 and waveforms of an output voltage applied to a load terminal thereof.
FIG. 3 is a graph depicting another embodiment of the control scheme for the switches of the pulse formation device shown in FIG. 1 and waveforms of an output voltage applied to the load terminal thereof.
FIG. 4 is a circuit diagram of a modification of the pulse formation device shown in FIG. 1.
FIG. 5A to FIG. 5D are graphs illustrating exemplary waveforms of output voltages formed by a pulse formation device according to the present invention.

### [Best Mode]

Hereinafter, exemplary embodiments of the present invention will be described in detail with reference to the accompanying drawings.

A pulse formation device 10 according to the present invention is a device configured to form a pulse waveform of an output voltage Vo applied to a load terminal L, and includes at least one first power module 100 connected to one end L1 of the load terminal L and at least one second power module 200 connected to the other end L2 of the load terminal L and to the first power module 100.

The output voltage Vo generated between both ends L1, L2 of the load terminal L of the pulse formation device 10 may be formed by the first power module 100 and the second power module 200.

The first power module 100 is a power source connected to the one end L1 of the load terminal L to generate a first output voltage V1 between both ends L1, L2 of the load terminal L and may have various configurations.

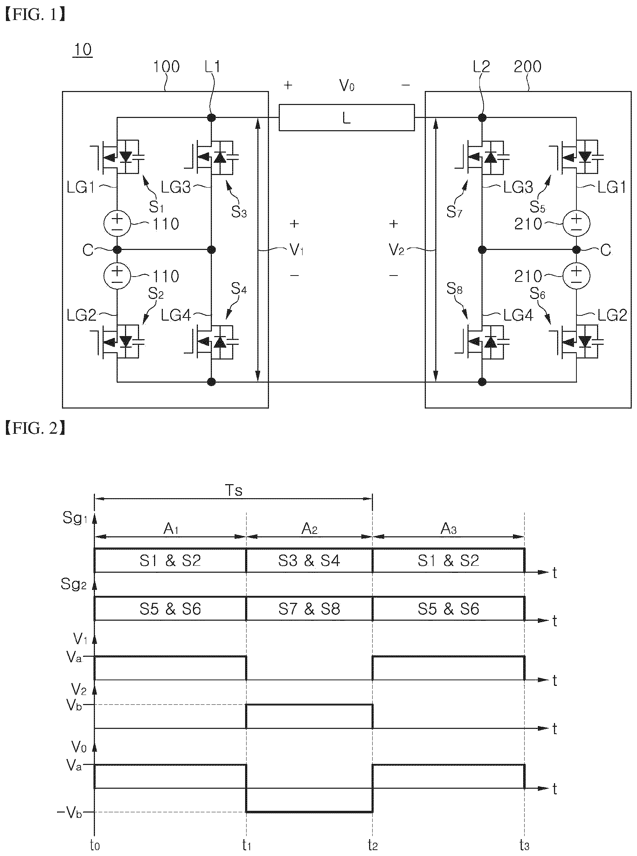

For example, the first power module 100 may include a plurality of first voltage sources 110 and a plurality of switches S1 to S4 independently turned on/off, as shown in FIG. 1.

The plurality of first voltage sources 110 may be DC voltage sources and the maximum voltage output from the plurality of first voltage sources 110 may be denoted by Va.

When the maximum voltage output from the plurality of first voltage sources 110 is Va, each of the first voltage sources 110 outputs the same voltage, and the number of first voltage sources 110 is denoted by K, the output voltage of each of the first voltage sources 110 may be Va/K.

For example, as shown in FIG. 1, when the first power module 100 includes two first voltage sources 110, the output voltage of each of the first sources 110 may be Va/2.

However, it should be understood that the scope of the present invention is not limited thereto and it is possible and desirable that at least one of the plurality of first voltage sources 110 be configured to have a different output voltage than the other first voltage sources 110.

The switches S1 to S4 are switching devices independently turned on or off and may have various configurations.

For example, the switches S1 to S4 may be power semiconductor devices and may be composed of various semiconductor devices, such as an SCR (thyristor), a TRIAC (triode AC switch), a GTO (gate turn-off thyristor), an IGBT (insulated gate bidirectional transistor), a MOSFET (metal oxide semiconductor field effect transistor), and the like, without being limited thereto.

By way of example, although the switches S1 to S4 are semiconductor switch devices shown as MOSFETs in FIG. 1, it should be understood that the switches are not limited thereto. When the switches S1 to S4 are configured as MOSFET switches, these switches can have an advantage in that a pulse rising time and a pulse falling time can be reduced, as compared to IGBT switches.

When the switches S1 to S4 are configured as MOSFETs, each of the switches S1 to S4 may be formed with three terminals, that is, a gate G, a drain D, and a source S, and may be turned on or off by a switch driving signal Vg applied to the gate G.

In another example, when the switches S1 to S4 are configured as IGBTs, each of the switches S1 to S4 may be formed with three terminals, that is, a gate G, a collector C, and an emitter E, and may be turned on or off by a switch driving signal Vg applied to the gate G.

The plurality of switches S1 to S4 may be configured to be independently turned on or off.

On the other hand, the first power module 100 may have an H-bridge circuit structure. That is, the plurality of switches S1 to S4 may be disposed on legs LG1 to LG4 of the H-bridge circuit, respectively.

Specifically, the first power module 100 may include four switches S1 to S4, that is, first to fourth switches S1 to S4, and the first to fourth switches S1 to S4 may be disposed on four legs LG1 to LG4 of the H-bridge circuit, respectively.

Referring to FIG. 1, a first switch S1 may be disposed on a first leg LG1 of the H-bridge circuit, a second switch S2 may be disposed on a second leg LG2 of the H-bridge circuit, a third switch S3 may be disposed on a third leg LG3 of the H-bridge circuit, and a fourth switch S4 may be disposed on a fourth leg LG4 of the H-bridge circuit.

In other words, the first to fourth switches S1 to S4 may be disposed on the legs LG1 to LG4 around a common node C of the H-bridge circuit, respectively.

Here, the first switch S1 and the third switch S3 may be electrically connected to the one end L1 of the load terminal L and the common node C of the H-bridge circuit between the one end L1 of the load terminal L and the common node C of the H-bridge circuit.

Similarly, the second switch S2 and the fourth switch S4 may be electrically connected to the common node C of the H-bridge circuit and the second power module 200 described below or another first power module 100 connected in series thereto between the common node C and the second power module 200 or the other first power module 100 connected in series thereto.

In addition, the drain D of the first switch S1 may be connected to the one end L1 of the load terminal L, whereas the source S of the third switch S3 may be connected to the one end L1 of the load terminal L unlike the first switch S1.

Similarly, the drain D of the second switch S2 may be electrically connected to the common node C, whereas the source S of the fourth switch S4 may be electrically connected to the common node C unlike the second switch S2.

When the first power module 100 includes two first voltage sources 110, one of the two first voltage sources 110 may be disposed between the first switch S1 and the common node C, and the other first voltage source 110 may be disposed between the second switch S2 and the common node C, as shown FIG. 1.

Accordingly, the first switch S1 and the second switch S2 are connected in series to the first voltage source 110 to allow the first output voltage V1 to be applied to the load terminal L when the first switch S1 and the second switch S2 are turned on.

The second power module 200 is a power module connected to the other end L2 of the load terminal L and connected to the first power module 100, and may have various configurations.

The second power module 200 is a power source connected to the other end L2 of the load terminal L to generate a second output voltage V2 between both ends L1, L2 of the load terminal L and may have various configurations.

For example, the second power module 200 may include a plurality of second voltage sources 110 and a plurality of switches S5 to S8 independently turned on or off, as shown in FIG. 1.

The plurality of second voltage sources 210 may be DC voltage sources and the maximum voltage output from the plurality of second voltage sources 210 may be Vb.

When the maximum voltage output from the plurality of second voltage sources 210 is Vb, each of the second voltage sources 210 outputs the same voltage, and the number of second voltage sources 210 is denoted by K, the output voltage of each of the second voltage sources 210 may be Vb/K.

For example, as shown in FIG. 1, when the second power module 200 includes two second voltage sources 210, the output voltage of each of the second voltage sources 210 may be Vb/2.

However, it should be understood that the scope of the present invention is not limited thereto and it is possible and desirable that at least one of the plurality of second voltage sources 210 be configured to have a different output voltage than the other second voltage sources 210.

Although the maximum voltage Vb of the second power module 200 may be the same as the maximum voltage Va of the first power module 100, it should be understood that the present invention is not limited thereto. Alternatively, the maximum voltage Vb of the second power module 200 may be different from the maximum voltage Va of the first power module 100.

The switches S5 to S8 are switching devices independently turned on or off and may have various configurations.

For example, the switches S5 to S8 may be power semiconductor devices and may be composed of various semiconductor devices, such as an SCR (thyristor), a TRIAC (triode AC switch), a GTO (gate turn-off thyristor), an IGBT (insulated gate bidirectional transistor), a MOSFET (metal oxide semiconductor field effect transistor), and the like, without being limited thereto.

By way of example, although the switches S5 to S8 are semiconductor switch devices shown as MOSFETs in FIG. 1, it should be understood that the switches are not limited thereto. When the switches S1 to S4 are configured as MOSFET switches, these switches can have an advantage in that a pulse rising time and a pulse falling time can be reduced, as compared to IGBT switches.

When the switches S5 to S8 are configured as MOSFETs, each of the switches S5 to S8 may be formed with three terminals, that is, a gate G, a drain D, and a source S, and may be turned on or off by a switch driving signal Vg applied to the gate G.

In another example, when the switches S5 to S8 are configured as IGBTs, each of the switches S5 to S8 is formed with three terminals, that is, a gate G, a collector C, and an emitter E, and may be turned on or off by a switch driving signal Vg applied to the gate G.

The plurality of switches S5 to S8 may be configured to be independently turned on or off.

On the other hand, the second power module 200 may have an H-bridge circuit structure. That is, the plurality of switches S5 to S8 may be disposed on legs LG1 to LG4 of the H-bridge circuit, respectively.

Specifically, the second power module 200 may include four switches S5 to S8, that is, fifth to eighth switches S5 to S8, and the fifth to eighth switches S5 to S8 may be disposed on four legs LG1 through LG4 of the H-bridge circuit, respectively.

Referring to FIG. 1, a fifth switch S5 may be disposed on a first leg LG1 of the H-bridge circuit, a sixth switch S6 may be disposed on a second leg LG2 of the H-bridge circuit, a seventh switch S7 may be disposed on a third leg LG3 of the H-bridge circuit, and an eighth switch S8 may be disposed on a fourth leg LG4 of the H-bridge circuit.

In other words, the fifth to eighth switches S1 to S4 may be disposed on the legs LG1 to LG4 around the common node C of the H-bridge circuit, respectively.

Here, the fifth switch S5 and the seventh switch S7 may be electrically connected to the other end L2 of the load terminal L and the common node C of the H-bridge circuit between the other end L2 of the load terminal L and the common node C of the H-bridge circuit.

Similarly, the sixth switch S6 and the eighth switch S8 may be electrically connected to the common node C of the H-bridge circuit and the first power module 200 described above or another second power module 100 connected in series thereto between the common node C and the second power module 200 or the other second power module 200 connected in series thereto.

In addition, the drain D of the fifth switch S5 may be connected to the other end L2 of the load terminal L, whereas the source S of the seventh switch S7 may be connected to the other end L2 of the load terminal L unlike the fifth switch S5.

Similarly, the drain D of the sixth switch S6 may be electrically connected to the common node C, whereas the source S of the eighth switch S8 may be connected to the common node C unlike the sixth switch S6.

When the second power module 200 includes two second voltage sources 210, one of the two second voltage sources 210 may be disposed between the fifth switch S5 and the common node C, and the other second voltage source 210 may be disposed between the sixth switch S6 and the common node C, as shown in FIG1.

Accordingly, the fifth switch S5 and the sixth switch S6 are connected in series to the second voltage source 210 to allow the second output voltage V2 to be applied to the load terminal L when the fifth switch S5 and the sixth switch S6 are turned on.

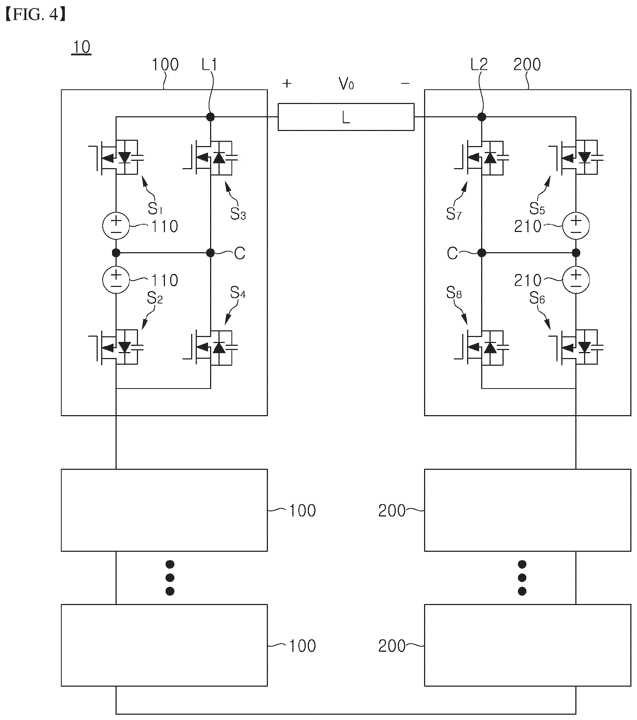

A plurality of the first power module 100 described above may be provided, and the plurality of first power modules 100 may be connected in series to each other, as shown in FIG. 4.

Similarly, a plurality of the second power module 200 described above may be provided, and the plurality of second power modules 200 may be connected in series to each other, as shown in FIG. 4.

When each of the first power module 100 and second power module 200 is provided in plural, the number of first power modules 100 may be the same as the number of second power modules 200.

On the other hand, each of the first to eighth switches S1 to S8 may include a capacitor C connected in parallel as an energy reservoir. Further, each of the first to eighth switches S1 to S8 may include a diode connected in parallel to ensure reliability of on/off operation.

The pulse formation device 10 may further include a controller that controls on/off of each of the first to eighth switches S1 to S8.

Referring again to FIG. 1, the first voltage source 110 and the second voltage source 210 may be connected to the load terminal L with opposite polarities.

Accordingly, a difference between the first output voltage V1 of the first power module 100 and the second output voltage V2 of the second power module 200 may be generated as an output voltage Vo between both ends of the load terminal L.

The first output voltage V1 and the second output voltage V2 may be formed at various voltage levels according to on-off operation of the first to eighth switches S1 to S8, and the difference between the first output voltage V1 and the second output voltage V2 may be generated between both ends L1, L2 of the load terminal L, whereby a waveform of a negative output voltage Vo or a waveform of various voltage levels can be applied to the load terminal L.

FIG. 2 is a graph depicting the first output voltage V1 and the second output voltage V2 output from the pulse formation device 100 shown in FIG. 1, and a time-dependent output voltage Vo applied to the load terminal L, and shows a pulse shape of the output voltage Vo applied to the load terminal L.

Referring to FIG. 2, Sg1 denotes a gate signal applied to the first power module 100, in which a drive signal is applied to the first switch S1 and the second switch S2 of the first power module 100 in a first interval A1 from t0 to t1, to the third switch S3 and the fourth switch S4 of the first power module 100 in a second interval A2 from t1 to t2, and to the first switch S1 and the second switch S2 of the first power module 100 in a third interval A3 from t2 to t3.

Thus, the first switch S1 and the second switch S2 may be simultaneously turned on in the first interval A1, and the third switch S3 and the fourth switch S4 may be simultaneously turned on in the second interval A2. Furthermore, the first interval A1 and the second interval A2 may be repeated (that is, the gate signal Sg1 of the first interval A1 is the same as the gate signal Sg1 of the third interval A3), wherein the repetition period may be Ts.

In response to the gate signal Sg1 applied to the first power module 100, the first to fourth switches S1 to S4 may be turned on or off to allow the first output voltage V1 to be output from the first power module 100. Referring to FIG. 2, since both the first switch S1 and the second switch S2 are turned on in the first interval A1, the first output voltage V1 may be a maximum voltage Va.

On the other hand, in the second interval A2, since the third switch S3 and the fourth switch S4 are turned on, the first output voltage V1 may be 0.

The third interval A3 is the repetition of the first interval A1 and, since both the first switch S1 and the second switch S2 are turned on in the third interval A3, the first output voltage V1 may be the maximum voltage Va.

Similarly, in FIG. 2, Sg2 denotes a gate signal applied to the second power module 200, in which a drive signal is applied to the fifth switch S5 and the sixth switch S6 of the second power module 200 in the first interval A1 from t0 to t1, to the seventh switch S7 and the eighth switch S8 of the second power module 200 in the second interval A2 from t1 to t2, and to the fifth switch S5 and the sixth switch S6 of the second power module 200 in the third interval A3 from t2 to t3.

Thus, the fifth switch S5 and the sixth switch S6 may be simultaneously turned on in the first interval A1, and the seventh switch S7 and the eighth switch S8 may be simultaneously turned on in the second interval A2. Furthermore, the first interval A1 and the second interval A2 may be repeated (that is, the gate signal Sg2 of the first interval A1 is the same as the gate signal Sg2 of the third interval A3), wherein the repetition period may be Ts.

In response to the gate signal Sg2 applied to the second power module 200, the fifth to eighth switches S5 to S8 may be turned on or off to allow the second output voltage V2 to be output from the second power module 200. Referring to FIG. 2, since both the fifth switch S5 and the sixth switch S6 are turned on in the first interval A1, the second output voltage V2 may be a maximum voltage Vb.

On the other hand, in the second interval A2, since the seventh switch S7 and the eighth switch S8 are turned on, the second output voltage V2 may be 0.

The third interval A3 is the repetition of the first interval A1 and, since both the fifth switch S5 and the sixth switch S6 are turned on in the third interval A3, the second output voltage V2 may be the maximum voltage Vb. Here, the maximum voltage Vb of the second output voltage V2 may be the same as the maximum voltage Va of the first output voltage V1.

Referring to FIG. 1, since the first output voltage V1 is equal to the sum of the second output voltage V2 and an output voltage Vo applied to the load terminal L, the output voltage Vo generated between both ends L1, L2 of the load terminal L may be a value obtained by subtracting the second output voltage V2 from the first output voltage V1. That is, the difference between the first output voltage V1 of the first power module 100 and the second output voltage V2 of the second power module 200 may be generated as an output voltage Vo between both ends of the load terminal L.

Referring again to FIG. 2, since a final output voltage Vo is a value obtained by subtracting the second output voltage V2 from the first output voltage V1, the final output voltage Vo may be Va in the first interval A1, -Vb in the second interval A2, and Va again in the third interval A3. The pulse formation device 10 according to the present invention allows a negative output voltage Vo to be applied to the load terminal L through combination of the first power module 100 and the second power module 200.

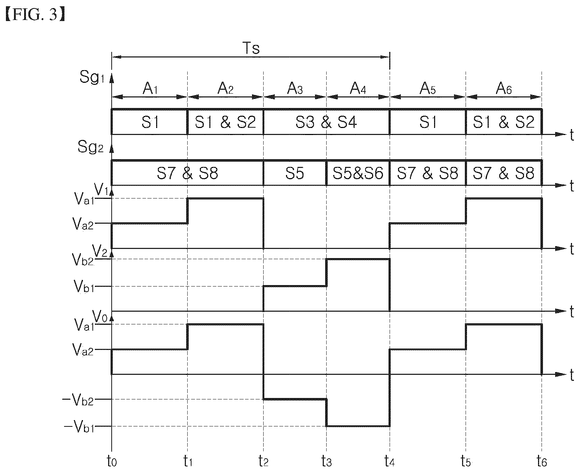

Next, FIG. 3 is a graph depicting the first output voltage V1 and the second output voltage V2 output from the pulse formation device 100 shown in FIG. 1, and a time-dependent output voltage Vo applied to the load terminal L, and shows another example of the pulse shape of the output voltage Vo applied to the load terminal L.

Referring to FIG. 3, Sg1 denotes a gate signal applied to the first power module 100, in which a drive signal is applied to the first switch S1 of the first power module 100 in a first interval A1 from t0 to t1, to the first switch S1 and the second switch S2 of the first power module 100 in a second interval A2 from t1 to t2, to the third switch S3 and the fourth switch S4 of the first power module 100 in third and fourth intervals A3, A4 from t2 to t4, again to the first switch S1 of the first power module 100 in a fifth interval A5 from t4 to t5, and to the first switch S1 and the second switch S2 of the first power module 100 in a sixth interval A6 from t5 to t6.

Thus, the first switch S1 may be turned on in the first interval A1, the first switch S1 and the second switch S2 may be simultaneously turned on in the second interval A2, the third switch S3 and the fourth switch S4 may be simultaneously turned on in the third and fourth intervals A3, A4, the first switch S1 may be turned on in the fifth interval A5, and the first switch S1 and the second switch S2 may be simultaneously turned on in the sixth interval A6. In addition, the first interval A1 to the fourth interval A4 may be repeated (that is., the gate signal Sg1 of the first interval A1 and the second interval A2 is the same as the gate signal Sg1 of the fifth interval A5 and the sixth interval A6), wherein the repetition period may be Ts.

In response to the gate signal Sg1 applied to the first power module 100, the first to fourth switches S1 to S4 may be turned on or off to allow the first output voltage V1 to be output from the first power module 100. Referring to FIG. 3, since the first switch S1 is turned on in the first interval A1, the first output voltage V1 may be Va2 (where Va2 denotes an output voltage of the first voltage source 110 connected in series to the first switch S1); and since both the first switch S1 and the second switch S2 are turned on in the second interval A2, the first output voltage V1 may be Va1 (where Va1 is the sum of the output voltages of the first voltage sources 110 connected in series to the first and second switches S1, S2), where Va1 may be the maximum voltage of the first output voltage V1.

On the other hand, in the third and fourth intervals A3, A4, since the third switch S3 and the fourth switch S4 are turned on, the first output voltage V1 may be 0.

The fifth and sixth intervals A5, A6 are the repetitions of the first and second intervals A1, A2, respectively. Here, since the first switch S1 is turned on in the fifth interval A5, the first output voltage V1 may be Va2, and since both the first switch S1 and the second switch S2 are turned on in the sixth interval A6, the first output voltage V1 may be the maximum voltage Va1.

Similarly, in FIG. 3, Sg2 denotes a gate signal applied to the second power module 200, in which a drive signal is applied to the seventh switch S7 and the eighth switch S8 of the second power module 200 in the first and second intervals A1, A2 from t0 to t2, to the fifth switch S5 of the second power module 200 in the third interval A3 from t2 to t3, to the fifth switch S5 and the sixth switch S6 in the fourth interval A4 from t3 to t4, and to the seventh switch S7 and the eighth switch S8 in the fifth and sixth intervals A5, A6 from t4 to t6.

Thus, the seventh switch S7 and the eighth switch S8 may be simultaneously turned on in the first and second intervals A1, A2; the fifth switch S7 may be turned on in the third interval A3; and the fifth switch S5 and the sixth switch S6 may be simultaneously turned on in the fourth interval A4. Furthermore, the first interval A1 to the fourth interval A4 may be repeated (that is, the gate signal Sg2 of the first and second intervals A1, A2 is the same as the gate signal Sg2 of the fifth and sixth intervals A5, A6), wherein a repetition period may be Ts.

In response to the gate signal Sg2 applied to the second power module 200, the fifth to eighth switches S5 to S8 may be turned on or off to allow the second output voltage V2 to be output from the second power module 200. Referring to FIG. 3, since both the seventh switch S7 and the eighth switch S8 are turned on in the first and second intervals A1, A2, the second output voltage V2 may be 0.

On the other hand, in the third interval A3, since the fifth switch S5 is turned on, the second output voltage V2 may be a voltage Vb2 of the second voltage source 210 connected in series to the fifth switch S5. In the fourth interval A4, since the fifth switch S5 and the sixth switch S6 are simultaneously turned on, the second output voltage V2 may be a voltage Vb1, that is, the sum of the voltages of the second voltage sources 210 connected in series to the fifth switch S5 and the sixth switch S6. Here, Vb1 may be the maximum voltage of the second output voltage V2.

The fifth and sixth intervals A5, A6 are the repetitions of the first and second intervals A1, A2, respectively, and since both the seventh switch S7 and the eighth switch S8 are turned on in the fifth and sixth intervals A5, A6, the second output voltage V2 may be 0.

Referring again to FIG. 3, since a final output voltage Vo is a value obtained by subtracting the second output voltage V2 from the first output voltage V1, the final output voltage Vo may be Va2 in the first interval A1, Va1 (the maximum value of a positive voltage) in the second interval A2, -Vb2 in the third interval A3, and -Vb1 (the maximum value of a negative voltage) in the fourth interval V4. The pulse formation device 10 according to the present invention allows a negative output voltage Vo to be applied to the load terminal L through combination of the first power module 100 and the second power module 200 and can form waveforms of the output voltage Vo at various voltage levels through individual control of on/off operation of the switches S1 to S8.

It is apparent that the sequence of on/off control of the first to eighth switches S1 to S8 in FIG. 2 and FIG. 3 is provided by way of example and may be changed in various ways to obtain a desired waveform, as needed. Furthermore, a method of controlling on/off of the first to eighth switches S1 to S8 to obtain the same type of waveform may also be changed in various ways. In other words, the output waveform of FIG. 2 or FIG. 3 may be realized through on/off control of the first to eighth switches S1 to S8 in a different manner.

Next, FIG. 4 shows another embodiment of the waveform formation device, in which each of the first power module 100 and the second power module 200 is provided in plural and an output voltage Vo of various voltage levels may be applied to the load L at a higher voltage than in FIG1.

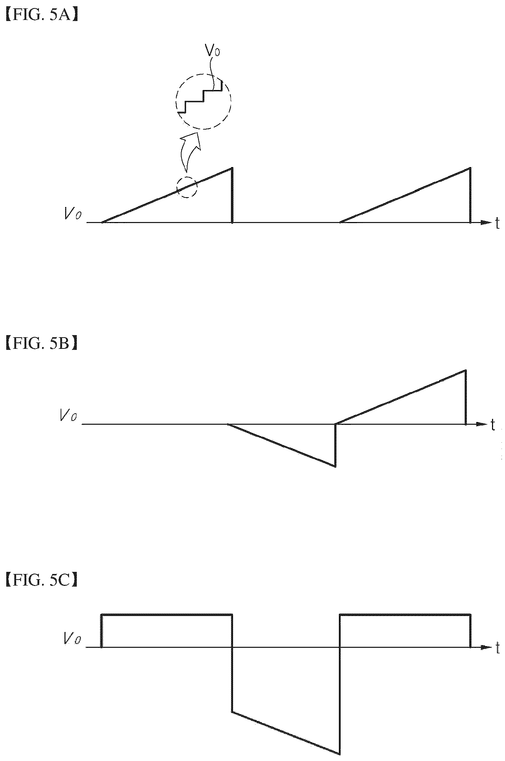

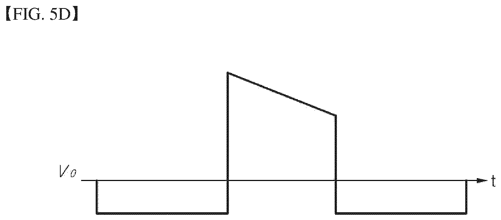

By way of example, FIG. 5A to FIG. 5D show various waveforms of the output voltage (Vo) that can be formed by the pulse formation device 10 shown in FIG. 4. The pulse formation device 10 according to this embodiment allows the output voltage Vo to be applied to the load terminal L in various forms, such as a form in which the output voltage Vo increases or decreases (referring to FIG. 5A, the output voltage Vo may increase or decrease in a stepwise manner according to switch on/off operation), a square pulse form, a DC offset, and combinations thereof.

The present invention also provides a pulse formation method using the above pulse formation device, in which the pulse formation method includes: a switching control step in which on/off operation of the plurality of switches S1 to S4 in the first power supply module 100 and a plurality of switches S5 to S8 in the second power supply module 200 is controlled; and an output step in which a difference between the first output voltage V1 of the first power module 100 and the second output voltage V2 of the second power module 200 is applied as an output voltage Vo to the load terminal L.

Although some exemplary embodiments have been described herein, it should be understood by those skilled in the art that these embodiments are given by way of illustration only and that various modifications, variations and alterations can be made without departing from the spirit and scope of the invention.

## Claims

1. A pulse formation device (10) comprising: at least one first power module (100) connected to one end (L1) of a load terminal (L); and at least one second power module (200) connected to the other end (L2) of the load terminal (L) and the first power module (100),
wherein the first power module (100) comprises a plurality of first voltage sources (110) and a plurality of switches (S1 to S4) independently turned on or off,
the second power module (200) comprises a plurality of second voltage sources (210) and a plurality of switches (S5 to S8) independently turned on or off, and
a difference between a first output voltage (V1) of the first power module (100) and a second output voltage (V2) of the second power module (200) is generated as an output voltage (Vo) between both ends of the load terminal (L).

2. The pulse formation device (10) according to claim 1, wherein a plurality of first power modules (100) are provided and connected in series.

3. The pulse formation device (10) according to claim 1, wherein a plurality of second power modules (200) are provided and connected in series.

4. The pulse formation device (10) according to claim 1, wherein the first power module (100) comprises two first voltage sources (110) and first to fourth switches (S1 to S4) disposed on four legs (LG1 to LG4) of an H-bridge circuit, respectively.

5. The pulse formation device (10) according to claim 1, wherein the second power module (200) comprises two first voltage sources (210) and fifth to eighth switches (S5 to S8) disposed on four legs (LG1 to LG4) of an H-bridge circuit, respectively.

6. The pulse formation device (10) according to claim 1, wherein each of the switches (S1 to S8) comprises a MOSFET.

7. The pulse formation device (10) according to claim 1, wherein
the first voltage source (110) and the second voltage source (210) are DC voltage sources and are connected to the load terminal (L) with opposite polarities.

8. The pulse formation device (10) according to claim 1, further comprising: a controller controlling on/off of the switches (S1 to S8).

9. The pulse formation device (10) according to claim 1, wherein each of the first voltage sources (110) and each of the second voltage sources (210) outputs the same magnitude of voltage.

10. A pulse formation method using the pulse formation device (10) according to any one of claims 1 to 10.
